# EUROPÄISCHE PATENTANMELDUNG

(11) **EP 0 639 044 A2**
(43) Veröffentlichungstag der Anmeldung: **15.02.1995**
(21) Anmeldenummer: 94112470.3
(22) Anmeldetag: 09.08.1994
(51) Int. Cl.: H05K 5/00

(54) **Wärmeleitfolie**

(30) Priorität: 12.08.1993 DE 4327144
(71) Anmelder: Siemens Nixdorf Informationssysteme AG, D-33106 Paderborn (DE)
(72) Erfinder: Seidel, Wolfgang, D-80689 München (DE)
(74) Vertreter: Fuchs, Franz-Josef, Dr.-Ing.

(57) **Zusammenfassung**

Zur Vereinfachung der Handhabung bei der Montage und Reparatur von Flachbaugruppen, gedruckten Schaltungsplatinen bzw. Multichipmodulen mit vielen integrierten Schaltkreisen (IS), die mit aufgesetzten Kühlkörpern (KK) gekühlt weden, wird vorgeschlagen, zwischen die Gehäuseoberflächen (GO) der integrierten Schaltkreise (IS) und den Kühlkörpern (KK) eine nur einmal zu montierende gemeinsame Wärmeleitfolie (WF) einzufügen, die eine mäanderförmige Perforierung in der Weise aufweist, daß den Kontaktflächen zwischen den integrierten Schaltkreisen (IS) und den jeweiligen Kühlkörpern (KK) zugeordnete Einzelflächen (EF) vorhanden sind, die in begrenztem Umfang gegeneinander federn in unterschiedlichen Höhen entsprechend der Höhen der Gehäuseoberflächen (GO) der integrierten Schaltkreise (I) anordenbar sind.

## Beschreibung

Die Erfindung betrifft eine Wärmeleitfolie gemäß dem Oberbegriff des Anspruchs 1.

Um die Zuverlässigkeit von integrierten Schaltkreisen und Leistungshalbleitern auf Flachbaugruppen oder Multichipmodulen zu verbessern, wird die Verlustleistung durch Montage von Kühlkörpern und erzwungene Konvektion der Umgebungslust oder durch Waserkühlung abgeführt. Ein guter Wärmeübergang vom integrierten Schaltkreis an den Kühlkörper wird erreicht durch planparallele Oberflächen, Wärmeleitpasten oder Wärmeleitkleber, oder einzelne in der Bauform angepaßte Wärmeleitfolien.

Planparallele Oberflächen, geklebte Verbindungen und die Einzelmontage von Wärmeleitfolien sind arbeitsintensiv und teuer. Wärmeleitpaste ist besonders im Fall einer Reparatur ungünstig zu handhaben und die Bauteile sind schwierig zu reinigen.

Eine Anwendung für Wärmeleitfolien ist beispielsweise aus dem Dokument GB 22 14 719 bekannt. Insbesondere ist hieraus eine Wärmeleitfolie für auf einer Trägerfläche in zugehörigen Gehäusen angeordnete integrierte Schaltkreise mit jeweiligen aufgesetzten Kühlkörpern bekannt, die zwischen den Gehäuseoberlächen der integrierten Schaltkreise und den jeweiligen Kühlkörpern angeordnet ist.

Aufgabe der Erfindung ist es, eine Wärmeleitfolie der eingangs genannten Art anzugeben, die eine einfache Handhabung bei der Bewerkstelligung von guten Wärmeübergängen zwischen den integrierten Schaltkreisen und den zugehörigen Kühlkörpern, sowie bei Reparaturen gewährleistet und die preiswert sind.

Diese Aufgabe wird erfindungsgemäß durch eine Wärmeleitfolie gelöst, die die Merkmale des kennzeichnenden Teils des Anspruchs 1 aufweist.

Danach wird für die Vielzahl von integrierten Schaltkreisen oder Leistungshalbleitern eine gemeinsame Wärmeleitfolie mit mäanderförmiger Perforierung eingesetzt, die an den Kontaktflächen zwischen den Gehäuseoberflächen der integrierten Schaltkreise und den zugehörigen Kühlkörpern Einzelflächen aufweist, die sich den unterschiedlichen Höhen der Gehäuseoberflächen der integrierten Schaltkreise oder Leistungshalbleiter anpassen können.

Die gemeinsame Wärmeleitfolie ist nur einmal zu montieren. Wärmeleitpasten oder Wärmeleitkleber können entfallen. Sie ist daher sowohl bei der Montage, als auch bei der Demontage beispielweise bei Reparaturen entsprechend einfach zu handhaben. Da sie nur einmal für eine Vielzahl von integrierten Schaltkreisen oder Leistungshalbleitern hergestellt werden muß, ist sie entsprechend günstig zu fertigen.

Vorteilhafte Ausgestaltungen der Erfindung sind Gegenstand von Unteransprüchen.

Insbesondere können die am Rand der Wärmeleitfolie angeordneten und ins Freie ragenden Einzelschenkel von kreuzförmigen Freistanzungen als Justageschlitze verwendet werden.

Nachfolgend wird ein Ausführungsbeispiel der Erfindung anhand einer Zeichnung näher erläutert. Es zeigen
- Figur 1: eine Wärmeleitfolie gemäß der Erfindung in Seiten- und Draufsicht, und
- Figur 2: eine Wärmeleitfolie gemäß der Figur 1 im eingebauten Zustand.

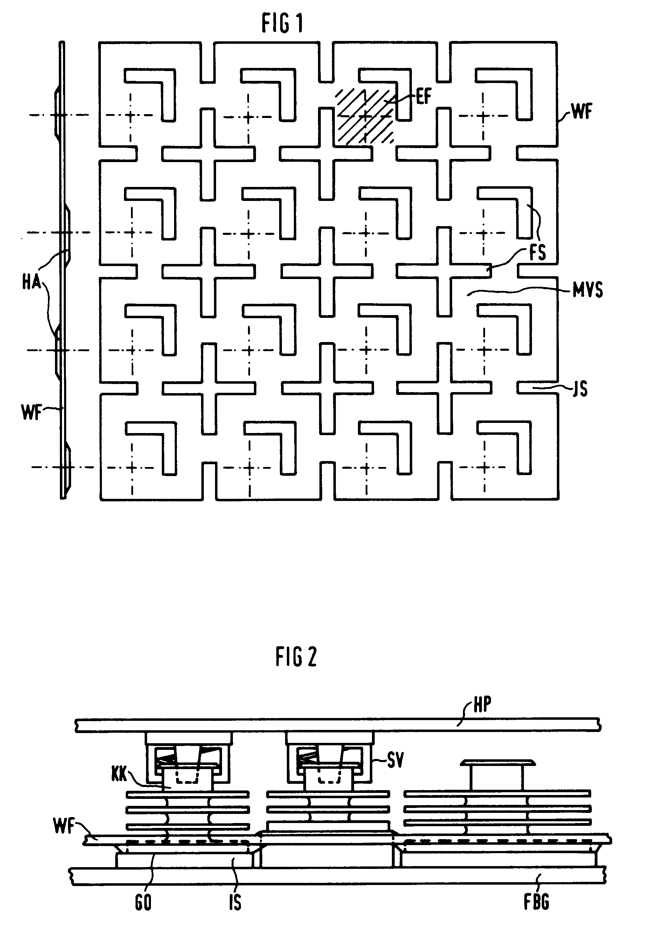

Die Draufsicht in der Figur 1 zeigt eine Wärmeleitfolie WF mit einer mäanderförmigen Perforierung. Durch die mäanderförmige Perforierung ergeben sich mäanderförmige Verbindungsstege MVS und Einzelflächen EF, von denen eine durch Schraffur besonders kenntlich gemacht ist.

Die Einzelflächen EF der Wärmeleitfolie WF sind jene Stellen der Wärmeleitfolie WF, die nach einer Montage der Wärmeleitfolie WF zwischen einer Gehäuseoberfläche GO (Figur 2) einer integrierten Schaltung IS (Figur 2), die beispielsweise auf einer Flachbaugruppe FBG (Figur 2) oder einem Multichipmodul montiert ist, und einem zugehörigen Kühlkörper KK (Figur 2) angeordnet sind und einen guten Wärmeübergang garantieren.

Neben der in der Figur 1 schraffierten Einzelfläche EF sind die übrigen Einzelflächen EF der Wärmeleitfolie WF durch Mittelpunktskoordinaten einer angedachten zugehörigen BausteinKühlkörper-Kombination markiert. Die Größe der Einzelflächen EF entspricht dabei jeweils der Kontaktfläche der jeweils zugeordneten Baustein-Kühlkörper-Kombination.

Die gemäß der Figur 1 angegebene mäanderförmige Perforierung erlaubt den Einzelflächen EF unabhängig von den jeweils anderen Einzelflächen EF in begrenztem Maß eine Höhenanpassung HA an unterschiedliche Höhen der Gehäuseoberflächen GO der integrierten Schaltkreise IS. Dieser Umstand ist in der SEitenansicht der Wärmeleitfolie in der Figur 1 angedeutet. Dabei ist die gewählte Höhe und Richtung der angezeigten Auswölbungen nur als beispielhaft anzusehen.

Wie in der Figur 1 ferner dargestellt ist, wird die mäanderförmige Perforierung der Wärmeleitfolie WF durch kreuzförmige und rechtwinkelig hakenförmige Freistanzungen FS gebildet. Gemäß dem Ausführungsbeispiel ist jeweils eine rechtwinkelig hakenförmige Freistanzung einer kreuzförmigen Freistanzung zugeordnet. Die rechtwinkelig hakenförmigen Freistanzungen sind den kreuzförmigen Freistanzungen jeweils in der Weise zugeordnet, daß eine rechtwinklig hakenförmige Freistanzung einem rechtwinkelig voneinander abstehenden Paar von Schenkeln einer kreuzförmigen Freistanzung an einer den senkrecht voneinander abstehenden Schenkeln der kreuzförmigen Freistanzung diagonal gegenüberliegenden Stelle spiegelbildlich zu den senkrecht voneinander abstehenden Schenkeln der kreuzförmigen Freistanzung angeordnet ist.

Die kreuzförmigen Freistanzungen sind mit den jeweils zugeordneten rechtwinklig hakenförmigen Freistanzungen gleichverteilt und gleichgerichtet auf der Wärmeleitfolie angeordnet. Dabei sind die kreuzförmigen Freistanzungen an gedachten Kreuzungspunkten von senkrecht aufeinander stehenden Linienscharen mit jeweils gleich konstant beanstandeten Einzellinien in der Weise angeordnet, daß die Schenkelachsen der kreuzförmigen Freistanzungen parallel zu den Linien der Linienschar verlaufen.

An den Rändern der Wärmeleitfolie WF sind einzelne Schenkel der kreuzförmigen Freistanzungen angeordnet, die in das Freie ragen und die als Justageschlitze JS dienen können.

In der Figur 2 ist eine montierte Wärmeleitfolie WF zu sehen. Die Wärmeleitfolie WF ist zwischen die Gehäuseoberflächen GO von auf einer Flachbaugruppe FBG montierten integrierten Schaltkreisen IS und den zugehörigen Kühlkörpern KK gespannt. Die Wärmeleitfolie WF ist den integrierten Schaltkreisen IS und Kühlkörpern KK gemeinsam zugeordnet, das heißt, für alle integrierten Schaltkreise IS und Kühlkörper KK gibt es nur eine einzige Wärmeleitfolie WF.

Gemäß dem Ausführungsbeispiel in Figur 2 werden die Kühlkörper KK durch Spannvorrichtungen SV, die auf einer gemeinsamen Halteplatte HP befestigt s ind, federnd auf die integrierten Schaltkreise IS gedruckt. Wie in der Figur 2 skizzenhaft dargestellt, passen sich die Einzelflächen EF der Wärmeleitfolie WF den Höhen der Gehäuseoberflachen GO der integrierten Schaltkreise IS jeweils entsprechend an.

Die Wärmeleitfolie WF ist vorzugsweise in einer Dicke von kleiner 0,07 mm gefertigt.

## Patentansprüche

1. Wärmeleitfolie für auf einer Trägerfläche in zugehörigen Gehäusen angeordnete integrierte Schaltkreise mit jeweiligen aufgesetzten Kühlkörpern, wobei zwischen den Gehäuseoberflächen (GO) der integrierten Schaltkreise (IS) und den jeweiligen Kühlkörpern (KK) eine gemeinsame Wärmeleitfolie (WF) angeordnet ist,
**dadurch gekennzeichnet,**
daß die Wärmeleitfolie (WF) in der Weise mäanderförmig perforiert ist, daß an den jeweiligen Kontaktstellen zwischen den Gehäuseoberflächen (GO) der integrierten Schalkreise (IS) und den jeweiligen Kühlkörpern (KK) Einzelflächen (EF) vorhanden sind, die in begrenztem Umfang gegeneinander federnd in unterschiedlichen Höhen anordenbar sind.

2. Wärmeleitfolie nach Anspruch 1,
**dadurch gekennzeichnet,**
daß die mäanderförmige Perforierung durch kreuz- und rechtwinklig hakenförmige Freistanzungen (FS) gebildet ist, von denen die rechtwinklig hakenförmigen Freistanzungen den kreuzförmigen Freistanzungen in der Weise zugeordnet sind, daß eine rechtwinklig hakenförmige Freistanzung einem rechtwinklig voneinander abstehenden Paar von Schenkeln einer kreuzförmigen Freistanzung an einer den senkrecht voneinander abstehenden Schenkeln der kreuzförmigen Freistanzung diagonal gegenüberliegenden Stelle spiegelbildlich zu den senkrecht voneinander abstehenden Schenkeln der kreuzförmigen Freistanzung angeordnet ist.

3. Wärmeleitfolie nach Anspruch 2,
**dadurch gekennzeichnet,**
daß jeweils eine rechtwinklig hakenförmige Freistanzung jeweils nur einer kreuzförmigen Freistanzung zugeordnet ist.

4. Wärmeleitfolie nach Anspruch 2 oder 3,
**dadurch gekennzeichnet,**
daß die kreuzförmigen Freistanzungen mit den jeweils zugeordneten rechtwinklig hakenförmigen Freistanzungen gleichverteilt und gleichgerichtet angeordnet sind.

5. Wärmeleitfolie nach einem der Ansprüche 2 bis 4,
**dadurch gekennzeichnet,**
daß die kreuzförmigen Freistanzungen an Kreuzungspunkten von senkrecht aufeinander stehenden Linienscharen mit jeweils gleich konstant beabstandeten Einzellinien in der Weise angeordnet sind, daß die Schenkelachsen der kreuzförmigen Freistanzungen parallel zu den Linien der Linienscharen verlaufen.

6. Wärmeleitfolie nach einem der Ansprüche 2 bis 5,
**dadurch gekennzeichnet,**
daß an den Rändern einzelne Schenkel der kreuzförmigen Freistanzungen angeordnet sind, die ins Freie ragen.
